(19) Europäisches Patentamt
European Patent Office
Office européen des brevets

(11) Veröffentlichungsnummer: **0 115 550**
**B1**

(12) # EUROPÄISCHE PATENTSCHRIFT

(45) Veröffentlichungstag der Patentschrift: **29.07.87**

(51) Int. Cl.[4]: **H 01 L 21/285**

(21) Anmeldenummer: **83101059.0**

(22) Anmeldetag: **04.02.83**

(54) **Verfahren zur Herstellung von Ohm'schen und/oder Schottky-Sperrschichtkontakten auf Halbleitersubstraten.**

(43) Veröffentlichungstag der Anmeldung:
**15.08.84 Patentblatt 84/33**

(45) Bekanntmachung des Hinweises auf die Patenterteilung:
**29.07.87 Patentblatt 87/31**

(84) Benannte Vertragsstaaten:
**DE FR GB**

(56) Entgegenhaltungen:
**DE-A-2 702 282**
**DE-A-2 758 576**

**IBM TECHNICAL DISCLOSURE BULLETIN, Band 21, Nr. 3, August 1978, Seiten 1054-1057, New York, US. W-K. CHU et al.: "Oxygen gettering in transition metals for stable low barrier height Schottky diodes"**

(73) Patentinhaber: **IBM DEUTSCHLAND GMBH**
**Pascalstrasse 100**
**D-7000 Stuttgart 80 (DE)**
(84) **DE**

(73) Patentinhaber: **International Business Machines Corporation**
**Old Orchard Road**
**Armonk, N.Y. 10504 (US)**
(84) **FR GB**

(72) Erfinder: **Bauer, Hans-Jürgen, Dr. Dipl.-Phys.**
**Landhausstrasse 51**
**D-7030 Böblingen (DE)**
Erfinder: **Garben, Bernd, Dr. Dipl.-Phys.**
**Donauschwabenstrasse 13**
**D-7036 Schönaich (DE)**

(74) Vertreter: **Kreidler, Eva-Maria, Dr. rer. nat.**
**Schönaicher Strasse 220**
**D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 115 550 B1

**Beschreibung**

Die Erfindung betrifft ein Verfahren zum Herstellen von Ohm'schen und/oder Schottky-Sperrschichtkontakten auf einem aus N-leitendem Silicium bestehenden Halbleitersubstrat durch Beschichten von Teilen des gereinigten Substrats mit einem ersten Metall aus der Gruppe von Platin, Palladium, Nickel, Rhodium, Zirkon, Hafnium und anschließende Sinterung und durch Beschichten des dabei gebildeten Metallsilicids bzw. eines weiteren freigelegten Teils des Halbleitersubstrats mit einem zweiten Metall aus der Gruppe von Aluminium, Tantal, Titan, Wolfram oder Titan-Wolfram.

Die Anforderungen an ein Material oder an eine Kombination von Materialien für Ohm'sche und Schottky-Kontakte auf Halbleitersubstraten sind sowohl vom elektrischen als auch vom chemischen Standpunkt aus außerordentlich streng. Es wurden zahlreiche, beim Entwurf von Halbleiterschaltungen bekannte metallurgische Systeme für Ohm'sche Kontakte und Schottky-Sperrschichtkontakte vorgeschlagen und benutzt. Das wohl am meisten und mit größtem Erfolg bei der Metallisierung von integrierten Schaltungen verwendete Metall ist Aluminium oder ein mit einer geringen Menge von Kupfer oder Silicium dotiertes Aluminium. Mit Aluminium lassen sich an Silicium und den umgebenden Isolierschichten gute Ohm'sche und mechanishe Kontakte herstellen. Aluminium kann auch durch Verdampfung oder Kathodenzerstäubung leicht aufgetragen und durch Ätzen oder ähnliche Verfahren leicht in Leiterzugmuster umgewandelt werden. Nachteilig an dem System Siliciumhalbleitersubstrat-Aluminium ist jedoch, daß Aluminium, insbesondere bei höheren Verfahrenstemperaturen, mit Silicium reagiert, wodurch Kurzschlüsse zwischen dem Aluminium und dem Halbleitersubstrat hergestellt werden. Außerdem sind die elektrischen Eigenschaften der Aluminium-Silicium Sperrschichtkontakte wegen des ungleichmäßigen Legierungsverhaltens schwierig zu überwachen.

Man hat deshalb bie der Herstellung von Ohm'schen und Schottky-Sperrschichtkontakten an Siliciumhalbleitersubstraten in Verbindung mit darüberliegenden Metallisierungen die Verwendung verschiedener Silicide wie Platinsilicid, Palladiumsilicid, Nickelsilicid, Rhodiumsilicid, Zirkoniumsilicid, Hafniumsilicid und dgl. vorgeschlagen. Ein Hinweis auf den Stand der Technik findet sich im IBM Technical Disclosure Bulletin Bd. 13, Nr. 3, August 1970, S. 646—648 in C. I. Kirchner und H. N. Yu, "Fabricating a Gate Field-Effect Transistor".

In der US-Patentschrift 3 274 670 sind elektrische Kontaktverbindungen mit Halbleitervorrichtungen mit niedrigem Widerstand beschrieben und insbesondere die Verwendung von Platin und die Bildung von Platinsilicid in Kombination mit einer zusammengesetzten Schicht aus Platin, Titan und Gold.

In der US-Patentschrift 3 290 127 ist die Bildung einer aktiven Kontaktschicht aus Palladiumsilicid beschrieben, die mit dem Halbleitermaterial eine Oberflächensperrschicht bildet. Leitungen oder Kontakte sind an eine Silber-Gold-Metallisierung angeschlossen. In dieser Patentschrift ist angegeben, daß anstelle von Palladium auch andere Metalle wie Nickel, Kupfer, Rhodium, Platin, Wolfram oder Molybdän verwendet werden können.

In der US-Patentschrift 3 893 160 ist ein Widerstandskontakt zu einem Siliciumhalbleitersubstrat mit einer Schichtenfolge Platinsilicid, Titan, Molybdän, Gold beschrieben.

Zur Herstellung von Schottky-Sperrschichtdioden ist z.B. aus der US-Patentschrift 3 906 540 bekannt, auf der Oberfläche eines aus N-leitendem Silicium bestehenden Halbleiterkörpers ein metallisches Silicid, z.B. Platinsilicid, zu bilden, eine Sperrschicht aus einem hochschmelzenden Metall aus der Gruppe von Molybdän, Titan, Wolfram, Tantal und dann eine Aluminiumschicht aufzubringen, wobei der Halbleiterkörper nach dem Aufbringen der Sperrschicht gesintert wird, um Verunreinigungen zwischen Substratoberfläche und Sperrschicht zu entfernen.

Aus der US-Patentschrift 3 995 301 ist eine Schottky-Sperrschichtstruktur bekannt, bei der eine Metallschicht aus $Al_2Pt$ mit einer Halbleiterzone mit hohem Widerstand in Kontakt ist. Die Struktur wird hergestellt durch Bilden einer Platinsilicidschicht auf einem Siliciumsubstrat, Aufbringen einer Aluminiumschicht und Sintern der Struktur während einer Stunde bei mindestens 400°C.

Zusammenfassend ist festzustellen, daß in der Literatur eine Vielzahl metallurgischer Systeme beschrieben sind, die eine oder mehrere Funktionen metallischer Kontakte erfüllen. Ein besonders erfolgreiches System für Ohm'sche Kontakte ist Platinsilicid/Aluminium und für Schottky-Sperrschichtkontakte ein System, bei der zwischen Aluminium und der Silicidschicht eine Sperrschicht aus Chrom, Titan, Wolfram oder einer Titan-Wolframlegierung angeordnet ist.

Die in der zuvor abgehandelten Literatur für Kontaktmetallisierungen als geeignet beschriebenen Metalle werden in der Regel auf sorgfältig gereinigte Siliciumhalbleitersubstrate, auf denen sich eine Maskenschicht zur Definition der gewünschten Kontaktöffnungen befindet, durch Elektronenstrahlverdampfung oder Kathodenzerstäubung im Hochvakuum bei Temperaturen größer etwa 350°C aufgetragen. Bei diesen Auftragungsverfahren im Hochvakuum treten eine Reihe von Problemen auf, die bisher noch nicht zufriedenstellend gelöst werden konnten. Es wurde beispielsweise bei der Herstellung von Platinsilicid-Halbleiterkontakten durch Aufdampfen von Platin im Hochvakuum bei ungefähr 350°C und Sintern beobachtet, daß die Ausbildung von Platinsilicid im Kontaktbereich durch eine sauerstoffreiche Schicht behindert wird. Auf diese Schicht, die durch Auger-Elektronenspektroskopie nachgewiesen werden konnte, ist auch die Verschlechterung der elektrischen Eigenschaften der Kontakte zurückzuführen. Es wurden hohe Übergangswiderstände und ein nicht lineares Kennlinienverhalten bei den so hergestellten Schottky-Sperrschichtdioden beobachtet. Durch Unterätzung der sauerstoffreichen Schicht beim Reinigen der Kontakte vor dem Aufdampfen der Aluminiummetallisierung konnte es sogar zur vollständigen Ablösung des Platinsilicids kommen. Beim Aufbringen anderer Metalle zur Kontaktierung von Halbleitersubstraten wurden ähnliche Erscheinungen beobachtet.

Bisher wurde angenommen, daß es sich bei der festgestellten sauerstoffreichen Schicht um eine dünne Siliciumdioxidschicht handelt, die bei einer Prozeßtemperatur von etwa 350°C infolge der verbleibenden Reste an Sauerstoff und Wasserdampf in der Vakuumkammer aufder freigelegten Siliciumsubstratoberfläche im Kontaktbereich aufwächst. Es wurde deshalb versucht, durch eine Reduzierung des Sauerstoffgehalts in der Vakuumkammer das Verhalten der Kontakte zu verbessern. Hierzu haben folgende Verfahren bisher Anwendung gefunden: Zunächst wurde durch Einbau einer Meißnerfalle und Kryopumpe das Vakuum verbessert. Dies führte, wegen des Einkühlens und Aufwärmens der Meißnerfalle zu einer verlängerten Zykluszeit und damit einem geringeren Probendurchsatz.

In einem anderen Verfahren wurde die Substrattemperatur während des Niederschlagens der Platinschicht reduziert. Nachteilig daran war die noch schlechtere Haftung des Platinsilicidfilms auf dem Siliciumhalbleitersubstrat und daraus resultierende, schlechte elektrische Kontakteigenschaften. Man hat auch versucht, den Platinfilm auf kalte Siliciumwafer niederzuschlagen und die Scheiben während des Niederschlagens auf die gewünschte Temperatur von etwa 350°C hochzuheizen. Dieses Verfahren ist schwierig zu kontrollieren und daher für einen Produktionsbetrieb nicht geeignet.

Die Reinigung der Substratoberfläche mittels Hochfrequenz-Kathodenzerstäubung in einer Vakuumkammer vor dem Niederschlagen eines Metallfilms wurde untersucht und ist in der Literatur (z.B. von R. M. Anderson, T. M. Reith, J. El. Chem. Soc., Vol. 122, 1337 (1975)) ausführlich beschrieben. Dieses Verfahren führt zwar zu einer Reinigung der Substratoberfläche, aber infolge Rückzerstäubung gelangen während der Reinigung Eisen, Nickel und andere metallische Verunreinigungen auf die Oberfläche der Siliciumwafer und damit in die Kontakte. Auch Sauerstoff ist neben diesen Verunreinigungen stets nachweisbar.

Aufgabe der Erfindung ist, ein verbessertes Verfahren zur Herstellung von Ohm'schen und/oder Schottky-Sperrschichtkontakten anzugeben, bei dem der Sauerstoffgehalt in Hochvakuumanlagen reduziert wird und oxidfreie Metallsilicid- bzw. Metall-Siliciumkontakte erhalten werden können.

Die Aufgabe der Erfindung wird gelöst durch ein Verfahren gemäß Patentanspruch 1.

Das erfindungsgemäße Verfahren eignet sich sowohl zur Herstellung oxidfreier Ohm'scher Kontakte als auch oxidfreier Schottky-Sperrschichtkontakte.

Bei der Ausbildung von Silicidschichten von Metallen aus der Gruppe von Platin, Palladium, Nickel, Rhodium, Zirkon, Hafnium und dgl., die durch Aufdampfen oder Aufstäuben der entsprechenden Metalle im Hochvakuum bei Temperaturen oberhalb erwa 350°C hergestellt werden, wird, wie bereits zuvor ausgeführt wurde, eine sauerstoffreiche Schicht gebildet, die durch Auger-Elektronenspektroskopie nachgewiesen werden kann. Von den Erfindern wurde gefunden, daß während des Heizens vor dem Niederschlag des Metalls praktisch kein Oxid auf der Siliciumsubstratoberfläche aufwächst. Die Oxidation der Siliciumoberfläche unter Ausbildung einer dünnen Siliciumdioxidschicht findet erst im Augenblick des Auftreffens der ersten Atomlagen von Metall an der Siliciumsubstratoberfläche statt. Sie ist vermutlich auf eine katalytische Wirkung des Platins oder der oben genannten anderen Metalle zurückzuführen. Das sich niederschlagende Metall bewirkt, daß sich eine sauerstoffreiche Schicht auf dem Silicium schon bei einer relativ niedrigen Temperatur ab etwa 330°C ausbildet. Obwohl die katalytische Wirkung von Platin und anderer der oben genannten Metalle bekannt ist und in zahlreichen Verfahren Anwendung findet, wurde ihr Einfluß auf die Ausbildung von Silicumdioxid bisher nicht erkannt.

Das erfindungsgemäße Verfahren macht von der störenden Oxidation der Siliciumsubstratoberfläche bei der Metallbedampfung Gebrauch zur wirksamen Reduzierung des Sauerstoffgehalts in Hochvakuumanlagen und stellt ein einfaches und wirkungsvolles Verfahren zur Herstellung oxidfreier Metallsilicidkontakte dar.

Aus der deutschen Offenlegungsschrift 2 758 576 ist zwar ein Hochtemperaturverfahren zum Mindern der bei der Herstellung von Silicium-Halbleiterbauelementen in das dotierte Halbleiterplättchen in Spuren gelangenden unerwünschten Schwermetalle Nickel, Kupfer, Eisen und Gold in einem Quarzrohr bekannt, bei dem in dem Quarzrohr ein Halbleiterplättchen oder mehrere in der Längsachse des Quarzrohres schichtweise mit Abstand hintereinandergereihte, verdrahtungslose Halbleiterplättchen je zwischen rohe, undotierte Siliciumscheiben hoher Rinheit gestellt werden, und bei dem in dem versiegelten Quarzrohr bei etwa 1100°C eine Inertgasatmosphäre von etwa $1{,}33 \times 10^{-9}$ bar während einer Verfahrensdauer von mindestens etwa 10 bis 60 Minuten gehalten wird. Während in dem Verfahren gemäß dieser Offenlegungsschrift Spuren unerwünschter Schwermetalle beseitigt werden, wird in dem vorliegenden einfachen Verfahren der Sauerstoffgehalt in Hochvakuumanlagen wirkungsvoll reduziert, wodurch die Herstellung oxidfreier Metallsilicidkontakte ermöglicht wird.

Zur Erzeugung oxidfreier Metallsilicidkontakte wird eine evakuierbare Kammer verwendet, in der sich der Substrathalter befindet. Ein Sektor des Substrathalters wird mit frisch gereinigten Siliciumhalbleitersubstraten belegt, während die verbleibenden Positionen des Substrathalters mit Siliciumhalbleitersubstraten mit integrierten Schaltungen beladen werden. Alle Siliciumscheiben im Substrathalter werden dann, wie üblich, im Hochvakuum auf die gewünschte Substrattemperatur von etwa 330 bis 550°C aufgeheizt. Beim anschließenden Bedampfen bzw. Zerstäuben wird der Sektor des Substrathalters mit den Siliciumhalbleitersubstraten mit integrierten Schaltungen von der Quelle des gewünschten Metalls durch eine Blende ausgeblendet, so daß das Metall zunächst nur auf den Siliciumhalbleitersubstraten ohne integrierte Schaltungen niedergeschlagen wird. Der in der Vakuumkammer vorhandene, restliche Sauerstoff wird von diesen Scheiben chemisorbiert, bis das Vakuum praktisch sauerstofffrei ist. Dann wird die Blende geöffnet und die Bedampfung bzw. Zerstäubung auf den Siliciumhalbleitersubstraten mit integrierten Schaltungen fortgesetzt. Versuche haben gezeigt, daß schon nach wenigen Sekunden der in der üblichen Verdampfungsanlage für Produktionsbetriebe vorhandene Sauerstoff vollständig chemisorbiert ist. Auger-Elektronenspektroskopieprofile, die an auf diese Weise hergestellten Platinsilicidkontakten aufgenommen wurden, zeigen weder an der Platinsilicid/Silicium-Grenzfläche noch inmitten des Platinsilicidfilms Sauerstoff.

Das erfindungsgemäße Verfahren kann auch zur Herstellung von Schottky-Sperrschichtdioden mit niedriger Barrierenhöhe gemäß der europäischen Patentschrift 743 (78 100 525.1) verwendet werden. Bei diesem Verfahren wird Tantal als Elektrodenmaterial verwendet, welches bei sehr niedrigen Drücken im Verdampfer auf die geöffneten Siliciumkontaktlöcher niedergeschlagen wird. Eine ausgezeichnete Konstanz der elektrischen Werte kann erreicht werden, wenn vor dem Niederschlagen des Tantalfilms auf die Siliciumkontakte frisch geätzte Siliciumhalbleitersubstrate mit Tantal bedampft werden. In der selben Vakuumkammer wird dann die Bedampfung der Siliciumkontaktlöcher vorgenommen.

Die Erfindung wird nunmehr anhand eines Ausführungsbeispiels in Verbindung mit den beigefügten Zeichnungen im einzelnen beschreiben.

Es zeigen:

Fig. 1 in den Teilfiguren 1A bis 1F Teilschnittansichten einer Halbleitervorrichtung während der verschiedenen Schritte ihres Herstellungsverfahrens,

Fig. 2 eine Vorrichtung zur Herstellung oxidfreier Ohm'scher oder Schottky-Kontakte.

Die Teilfigur 1A zeigt den Teil eines Halbleiterchips, welcher unter Anwendung des erfindungsgemäßen Verfahrens hergestellte Ohm'sche Kontakte und Schottky-Sperrschichtdioden enthalten soll. Das Substrat 1 des Halbleiterchips besteht beispielsweise aus P-leitendem Silicium, das einen spezifischen Widerstand von 10 Ω/cm aufweist. Auf diesem Substrat 1 befindet sich eine $N^-$-leitende Epitaxieschicht 3, die vorzugsweise eine Leitfähigkeit von $1 \times 10^{16}$ bis $8 \times 10^{16}$ Atome/cm$^3$ aufweist. In dem Substrat 1 sind zwei vergrabene Zonen 4 und 6 vorgesehen, die über Anschlußzonen 5 und 7 an die Oberfläche des Substrats 1 herangeführt sind. Das Substrat enthält außerdem eine $P^+$-leitende Subisolationszone 2, die in Verbindung mit einer $P^+$-leitenden Isolationszone 8 die $N^+$-leitenden Zonen gegeneinander isoliert.

Die Zonen 2, 4 und 6 werden in vorteilhafter Weise durch Eindiffundieren der entsprechenden Störelemente durch Öffnungen hergestellt, die in einer die Oberfläche des Substrats 1 bedeckenden Schicht (nicht dargestellt) vorgesehen sind. $N^+$-Leitung hervorrufende Störelemente sind Arsen oder Phosphor, ein $P^+$-Leitung hervorrufendes Störelement ist Bor.

Die Maskenschicht wird dann durch übliche Ätzverfahren vom Substrat 1 entfernt und die Schicht 3 mittels Epitaxie aufgewachsen, wobei die Zonen 2, 4 und 6 durch Ausdiffusion in die Schicht 3 eindringen. Eine Maskenschicht, die in bekannter Weise aus einer Siliciumdioxidschicht 9 und einer Siliciumnitridschicht 10 zusammengesetzt ist, wird auf der Oberfläche der Schicht 3 gebildet, und in dieser Maskenschicht werden Öffnungen hergestellt, durch die die $N^+$-bzw. $P^+$-Leitung erzeugenden Störelemente zur Bildung der Anschlußzonen 5 und 7 bzw. der Isolationszone 8 eindiffundiert werden.

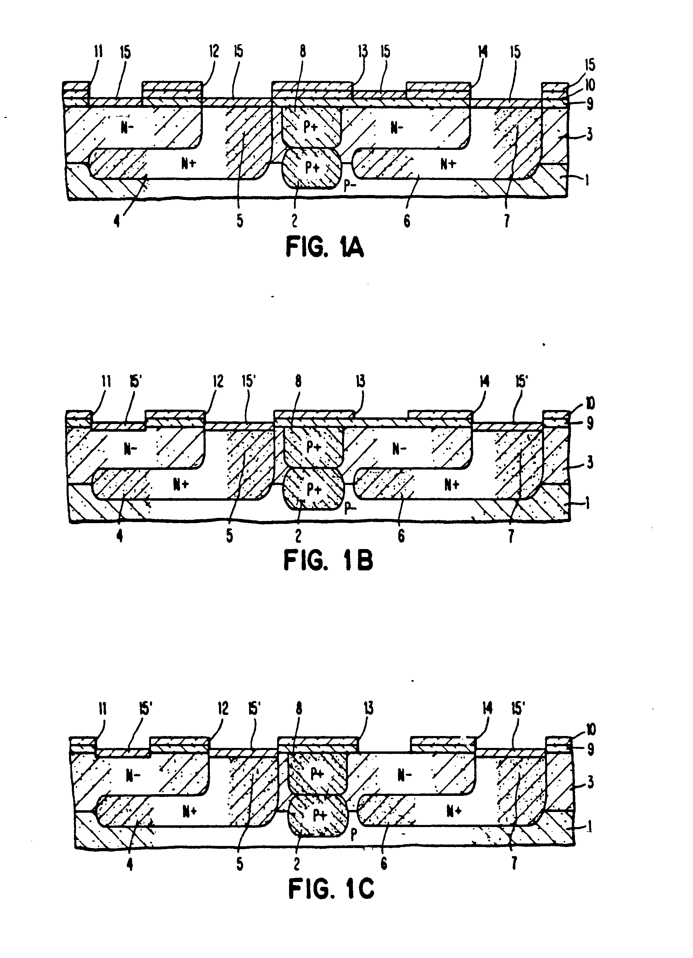

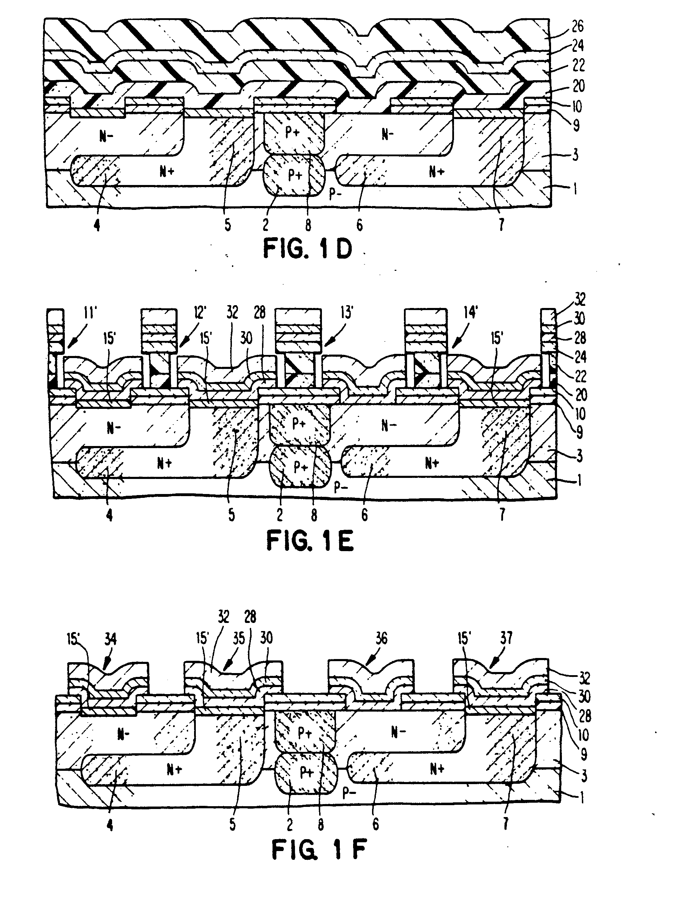

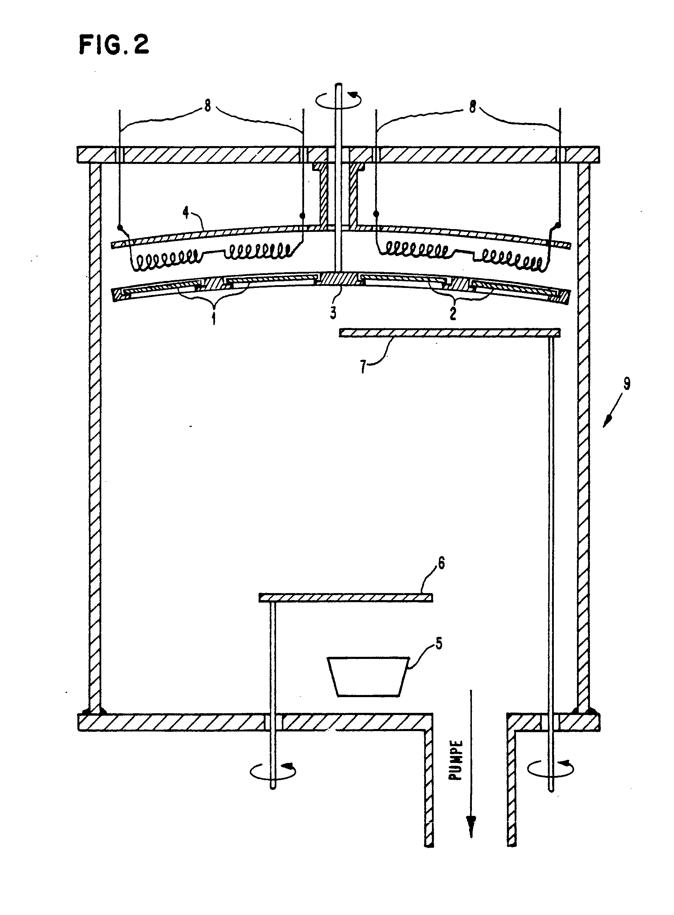

Anschließend wird, alles überdeckend, auf der Siliciumnitridschicht 10 und innerhalb der Öffnungen 11, 12, 13 und 14 eine Platinschicht 15 aufgetragen. Hierzu werden die in einer wässrigen Flußsäurelösung (Mischungsverhältnis von $H_2O$:HF gleich 15:1 bis 5:1) vorgereinigten Wafer auf einen Substrathalter 3 in einer Vakuumkammer 9 (Fig. 2) gegeben. Die Positionen des Substratshalters in Sektor 2 werden mit den Siliciumhalbleitersubstraten mit integrierten Schaltungen belegt. Die Positionen des Substrathalters in Sektor 1 werden mit frisch gereinigten nichtprozessierten Siliciumhalbleitersubstraten belegt, die keine integrierten Schaltungen enthalten. Alle Siliciumhalbleiterscheiben im Substrathalter werden dann wie üblich im Hochvakuum bei $1{,}33 \times 10^{-6}$ mbar über Heizelemente 8 auf eine gewünschte Substrattemperatur, beispielsweise auf 350°C, aufgeheizt. Beim anschließenden Bedampfen mit Platin bzw. beim Kathodenzerstäuben von Platin wird der Sektor 2 mit den Siliciumhalbleitersubstraten mit integrierten Schaltungen von der Platinquelle 5 durch eine Blende 7 ausgeblendet, so daß Platin zunächst nur auf den Silciumhalbleitersubstraten des Sektors 1, die keine integrierten Schaltungen enthalten, niedergeschlagen wird. Der in der Vakuumkammer vorhandene restliche Sauerstoff wird während des Auftreffens der ersten Atomlagen von Platin auf diesen Halbleitersubstraten chemisorbiert, so daß ein praktisch sauerstofffreies Hochvakuum erhalten wird. Es wurde festgestellt, daß in für den Produktionsbetrieb üblichen Verdampfungsanlagen der darin vorhandene Sauerstoff bereits nach wenigen Sekunden vollständig chemisorbiert wird. Nach diesem Zeitpunkt wird die Blende 7 geöffnet, und es erfolgt die Bedampfung bzw. die Kathodenzerstäubung von Platin auf die Siliciumhalbleitersubstrate mit integrierten Schaltungen des Sektors 2, bis eine Schichtdicke von etwa 40 nm aufgetragen ist. Die in der Öffnung 13 (Fig. 1A) vorhandene Siliciumdioxidschicht 9 verhindert, daß das Platin in dieser Öffnung mit dem Substrat 3 in Berührung kommt.

Gemäß Teilfigur 1B wird das Halbleiterchip dann etwa 20 Minuten lang bein einer Temperatur von 550°C in einer Stickstoffatmosphäre gesintert, wobei das Platin mit dem Silicium reagiert und in den Öffnungen 11, 12 und 14 Platinsilicidschichten 15' bildet. Das nichtumgesetzte Platin, einschließlich der über der Siliciumdioxidschicht 9 liegenden Platinschicht wird dann durch Ätzen mit Königswasser entfernt. Im nächsten Verfahrensschritt gemäß Teilfigur 1C wird der in der Öffnung 13 liegende Teil der Siliciumdioxidschicht 9 durch ein Naß- oder Trockenätzverfahren entfernt, wodurch der Teil des Substrats 3 freigelegt wird, welcher die Anode einer Schottky-Sperrschichtdiode mit niedriger Potentialschwelle bilden soll.

Das Niederschlagen eines Metallisierungssystems, beispielsweise von Tantal, in den Öffnungen 11 bis 14 wird dann vorgenommen. Das hierzu vorzugsweise angewendete Ablöseverfahren ist in der der Anmelderin gehörenden US-Patentschrift 4 004 044 eingehend beschrieben. Dieses Verfahren soll in abgekürzter Form anhand der Teilfiguren 1D bis 1F beschrieben werden. Andere Verfahren zur Herstellung der Metallisierung sind nasse oder reaktive Ionen- bzw. Plasmaätzverfahren, die dem Fachmann allgemein zugängig sind. Das Ablöseverfahren gestattet jedoch eine wesentlich bessere Definition der Metallisierung, wodurch die für die Verdrahtung erforderliche Fläche wesentlich herabgesetzt wird.

Gemäß Teilfigur 1D wird, alles überdeckend, eine dünne Schicht 20 aus Polyäthersulfon aufgebracht, die in Abänderung des in dem obengenannten Patent erwähnten Verfahrens im IBM Disclosure Bulletin, Bd. 19, Nr. 4, September 1976 auf Seite 1226 beschrieben ist. Über der Polyäthersulfonschicht 20 wird eine Schicht 22 aus einem organischen Polymeren aufgebracht, beispielsweise aus einem auf Novolakharzbasis aufgebauten positiven Photresist, der anschließend bei 210 bis 230°C gehärtet wird, so daß er nicht mehr photoempfindlich ist. Über der Photoresistschicht 22 wird eine aus einem Methylsiloxanharz bestehende Sperrschicht 24 aufgebracht und anschließend eine Schicht 26 aus einem strahlungsempfindlichen Photoresist.

Die Photoresistschicht 26 wird dann zur Herstellung des reliefartigen Musters entsprechend den Öffnungen 11, 12, 13 und 14 in der Teilfigur 1C belichtet und entwickelt. Die Photoresistmaske 26 dient zur selektiven Entfernung der darunterliegenden Schichten 20, 22 und 24 zum Freilegen der Öffnungen 11', 12', 13' und 14' gemäß Teilfigur 1E, die den in Teilfigur 1C gezeigten Öffnungen entsprechen.

Nach der Herstellung der Öffnungen wird das freiliegende Substrat einschließlich der Platinsilicidschicht 15 einer Vorreinigung unterzogen. Die Vorreinigung kann beispielsweise mit einer Mischung von Wasser und Flußsäure im Verhältnis 15:1 bis 5:1 unter genau überwachten Strahlungsbedingungen, die in dem der Anmelderin gehörenden europäischen Patent 743 beschrieben sind, vorgenommen werden. Mit diesem Verfahren können Schottky-Sperrschichtdioden mit niedriger Potentialschwelle von etwa 0,5 eVolt hergestellt werden. Es wurde auch versucht, die Halbleiteroberfläche in situ in einer Zerstäubungskammer durch Kathodenzerstäubung zu reinigen. Dieses Verfahren ergab zwar eine Potentialschwelle von etwa 0,5 eVolt, die sich aber nicht exakt wiederholen ließ.

Gemäß Teilfigur 1E wird, alles überdeckend, eine Metallisierungsschicht 28 über dem Substrat und der Ablösemaske aufgebracht. In dem vorliegenden Ausführungsbeispiel wird hierzu Tantal verwendet. Damit tatsächlich ein Schottky-Sperrschichtkontakt mit niedriger Potentialschwelle erzielt werden kann, muß der Niederschlag dieser Tantalschicht ebenfalls nach einem sehr sorgfältig durchgeführten Verfahren erfolgen. Der Niederschlag, der am bestem mit einer Elektronenstrahlverdampfungsquelle vorgenommen wird, soll in der gleichen Kammer, in der die Platinschicht 15 aufgetragen wurde, erfolgen. Der Anfangsdruck in der Kammer beträgt hierzu etwa $1{,}33 \times 10^{-9}$ mbar und der während des Verfahrens herrschende Druck etwa $1{,}33 \times 10^{-7}$ mbar. Die maximale Temperatur des Substrats beträgt 200°C. Der hier angegebene Druck ist für die Menge der in der Kammer vorhandenen Feuchtigkeit, Kohlenwasserstoffe und anderer gasförmiger Veruneinigungen von Bedeutung. Je höher der Druck, umso höher sind die Feuchtigkeit und der Anteil an Verunreinigungen, die leicht eine Oxidation der Tantalschicht hervorrufen können, so daß sich eine Potentialschwelle von mehr als 0,5 eVolt ergibt.

Es wurde festgestellt, daß trotz der besonderen Anforderungen an das Vakuum eine ausreichende Konstanz der elektrischen Werte der Schottky-Sperrschichtdioden nicht gewährleistet war und gelegentlich Ausbeuteverluste in Kauf genommen werden mußten. Die Reproduzierbarkeit der elektrischen Eigenschaften kann jedoch wesentlich verbessert werden, wenn vor der eigentlichen Bedampfung der Siliciumhalbleitersubstrate mit integrierten Schaltungen frisch geätzte, nichtprozessierte Siliciumhalbleitersubstrate mit Tantal bedampft werden. Hierzu wird Tantal gemäß Fig. 2 aus der Bedampfungsquelle 5 auf frisch geätzten Siliciumhalbleitersubstraten 1 niedergeschlagen. Bei der Bedampfung wird ein definierter Startpunkt mit der Blende 6 eingestellt. Nach etwa 30 Sekunden wird die Blende 7, die die Halbleitersubstrate 2 mit integrierten Schaltungen abschattet, zur Bedampfung derselben geöffnet. Die Bedampfung, die mit etwa 0,2 nm je Sekunde abläuft, wird solange fortgesetzt, bis eine Schichtdicke von 60 ± 15 nm erreicht ist. Die Beschichtung der Halbleitersubstrate mit Tantal kann durch Elektronenstrahlverdampfung, oder, unter gleichen Druck- und Temperaturbedingungen durch Hochfrequenzzerstäubung erfolgen. Die unter diesen Bedingungen erzeugte Tantalschicht besteht aus kubisch-raumzentrierten Kristallen.

Nach dem Aufbringen der Tantalschicht 28 wird eine Schicht 30 aus Chrom und eine Schicht 32 aus Aluminium oder aus mit Kupfer dotiertem Aluminium bzw. mit Kupfer dotiertem Aluminium-Silicium, vorzugsweise in der gleichen Verdampfungskammer niedergeschlagen. Die Chromschicht wird vorzugsweise bis zu einer Dicke von etwa 60 bis 100 nm unter Wasserdampfzufuhr zur Kammer niedergeschlagen. Das Substrat wird hierbei auf einer Maximaltemperatur von 160°C gehalten. Das unter Wasserdampfzufuhr niedergeschlagene Chrom wirkt als Sperrschicht zwischen Aluminium und Tantal.

Das Aluminium wird vorzugsweise bis zu einer Schichtdicke von etwa 850 bis 1000 nm niedergeschlagen. Ein mit einer geringen Menge Kupfer dotiertes Aluminium ist reinem Aluminium vorzuziehen. Teilfigur 1E zeigt die sich nach diesem Verfahrensschritt ergebende Struktur. Die Ablösestruktur (Bezugszeichen 20, 22 und 24) und die darüberliegenden Metallschichten 28, 30 und 32 werden unter Verwendung eines geeigneten Lösungsmittels, beispieswelse N-Methylpyrrolidon rasch abgehoben, so daß ein metallisches Muster auf der Oberfläche des Substrats oder der Oxidschicht 10 verbleibt, wie dies in Teilfigur 1F dargestellt ist. Dann wird diese Struktur etwa 1 Stunde lang bei 400°C und dann erneut für weitere 2 Stunden bei 450°C gesintert. Diese Sinterung ist erforderlich, um eine Höhe der Potentialschwelle von Schottky-Sperrschichtdioden von 0,5 eVolt zu erzielen. Damit ist das Grundverfahren beendet.

Eine Sperrschichtdiode mit hoher Potentialschwelle ist in Fig. 1F durch die Bezugszeichen, 34, 35 und eine Schottky-Sperrschichtdiode mit niedriger Potentialschwelle durch die Bezugszeichen 36, 37 gekennzeichnet. Unter Verwendung der gleichen Metallisierung (Tantal) wurden drei verschiedene Arten von Kontakten hergestellt. Die Kathoden 35, 37 beider Dioden sind die nach den $N^+$-leitenden Zonen 5 und 7 in der Schicht 3 führenden Ohm'schen Kontakte. Die Anode 34 der Schottky-Sperrschichtdiode mit hoher Potentialschwelle verwendet eine Chrom-Tantal-Metallisierung zwischen der Platinsilicidschicht 15 und der Aluminiumschicht 32, wobei die Chromschicht 30 als Diffusionssperre wirkt. Die Platinsilicidschicht 15 ergibt eine erhöhte Potentialschwelle, verglichen mit der Anode 36 der Schottky-Sperrschichtdiode mit niedriger Potentialschwelle, bei der keine Platinsilicidschicht vorhanden ist. In der Zone 36 berührt die Tantalschicht 28 das N-leitende Siliciumsubstrat 3 unmittelbar. Anstelle des Tantals, das in dem vorliegenden Verfahren alles überdeckend aufgetragen wird, können auch andere Metalle, beispielsweise Titan oder Titan-Wolfram verwendet werden.

Die Vorrichtung gemäß Fig. 2 dient zur Durchführung des erfindungsgemäßen Verfahrens. In einer Kammer 9 ist ein Substrathalter 3 drehbar angeordnet. Über dem Substrathalter 3 befinden sich Heizelemente 8 und Reflektoren 4. Die drehbar angeordnete Blende 7 gestattet die Abdekkung der Siliciumhalbleitersubstrate 2 in der Substrathalterung 3 in der Anfangsphase der Metallbedampfung. Mit 5 wird die Quelle eines gewünschten Metalls bezeichnet. Nach der Bedampfung der Siliciumhalbleitersubstrate 1 wird die Blende 7 zwischen Metallquelle 5 und den Siliciumhalbleitersubstraten 2 zur Bedampfung der Halbleitersubstrate 2 mit integrierten Schaltungen ausgeblendet. Die drehbar angeordnete Blende 6 gestattet die Einstellung eines definierten Startpunktes bei der Bedampfung. In der Kammer 9 kann mittels einer Pumpe (nicht dargestellt) Hochvakuum erzeugt werden.

**Patentansprüche**

1. Verfahren zum Herstellen von Ohm'schen und/oder Schottky-Sperrschichtkontakten auf einem aus N-leitendem Silicium bestehenden Halbleitersubstrat durch Beschichten von Teilen de gereinigten Substrats mit einem ersten Metall aus der Gruppe von Platin, Palladium, Nickel, Rhodium, Zirkon, Hafnium und anschließende Sinterung, und durch Beschichten des dabei gebildeten Metallsilicids bzw. eines weiteren freigelegten Teils des Halbleitersubstrats mit einem zweiten Metall aus der Gruppe von Aluminium, Tantal, Titan, Wolfram oder Titan-Wolfram, dadurch gekennzeichnet, daß zur Entfernung von Spuren von Sauerstoff in der Vakuumkammer das gewünschte Metall auf frisch gereinigte Siliciumhalbleitersubstrate bei niedrigem Druck und niedriger Temperatur und unmittelbar danach in derselben Kammer auf Siliciumkontaktlöcher von Halbleitersubstraten mit integrierten Schaltungen niedergeschlagen wird.

2. Verfahren nach Anspruch 1, dadurch gekennzeichnet, daß die gewünschten Metalle mittels Elektronenstrahlverdampfung oder mittels Hochfrequenzkathodenzerstäubung aufgebracht werden.

3. Verfahren nach den Ansprüche 1 und 2, dadurch gekennzeichnet, daß die Oberfläche der Siliciumhalbleitersubstrate zur Vorbereitung mit einer Ätzlösung gereinigt wird.

4. Verfahren nach den Ansprüchen 1 bis 3, dadurch gekennzeichnet, daß die Siliciumhalbleitersubstrate vor dem Niederschlagen des Metalls langsam auf die gewünschte Substrattemperatur aufgeheizt werden.

5. Verfahren nach Anspruch 4, dadurch gekennzeichnet, daß die Siliciumhalbleitersubstrate auf eine Temperatur im Bereich von 330 bis 550°C aufgeheizt werden.

6. Verfahren nach den Ansprüchen 1 und 2, dadurch gekennzeichnet, daß die gewünschten Metalle im Hochvakuum bei einem Druck im Bereich von $1{,}33 \times 10^{-6}$ bis $1{,}33 \times 10^{-7}$ mbar niedergeschlagen werden.

7. Verfahren nach Anspruch 1, dadurch gekennzeichnet, daß während des Niederschlagens von Metall auf die frisch gereinigten Siliciumhalbleitersubstrate die Siliciumhalbleitersubstrate mit integrierten Schaltungen von der Quelle des gewünschten Metalls durch eine Blende ausgeblendet sind.

8. Verfahren nach Ansprüchen 1 und 7, dadurch gekennzeichnet, daß das gewünschte Metall auf die frisch gereinigten Siliciumhalbleitersubstrate für etwa 30 Sekunden und dann auf die Siliciumhalbleitersubstrate mit integrierten Schaltungen für die der gewünschten Schichtdicke entsprechende Zeit niedergeschlagen wird.

9. Verfahren nach den Ansprüchen 1, 2 und 6, dadurch gekennzeichnet, daß die Halbleitersubstrate nach dem Aufbringen der ersten Metallschicht bei einer Temperatur von 550 bis 600°C für 15 bis 30 Minuten gesintert werden.

10. Vorrichtung zum Beschichten von Halbleitersubstraten mit Metall im Hochvakuum, gekennzeichnet durch einen in einer Vakuumkammer (9) drehbar angeordneten Substrathalter (3) mit den Abschnitten (1) und (2), eine Quelle (5) des aufzutragenden Metalls und eine Blende (7), mit der Siliciumhalbleitersubstrate mit integrierten Schaltungen im Abschnitt (2) von der Quelle (5) ausgeblendet werden können.

11. Vorrichtung nach Anspruch 10, dadurch gekennzeichnet, daß über dem Substrathalter (3) Heizelemente (8) mit Reflektoren (4) angeordnet sind.

12. Vorrichtung nach Anspruch 10, dadurch gekennzeichnet, daß zur Einstellung eines definierten Startpunktes bei der Verdampfung über der Quelle (5) eine Blende (6) drehbar angeordnet ist.

## Revendications

1. Procédé pour former des contacts ohmiques et/ou des contacts à barrière de Schottky sur un substrat semi-conducteur so composant de silicium de conductivité N par revêtement de parties du substrat nettoyé avec un premier métal du groupe platine, palladium, nickel, rhodium, zirconium, hafnium, suivi par un frittage, et par un revêtement du silicium métallique ainsi formé ou bien d'une autre partie exposée du substrat semi-conducteur avec un second métal du groupe aluminium, tantale, titane, tungstène ou titane-tungstène, caractérisé en ce que, pour enlever des traces d'oxygène de la chambre à vide, le métal désiré est déposé sur des substrats semi-conducteurs en silicium fraîchement nettoyés, sous une faible pression et à une température peu élevée, et immédiatement ensuite, dans la même chambre, sur des trous de contacts en silicium de substrats semi-conducteurs avec circuits intégrés.

2. Procédé selon la revendication 1, caractérisé en ce que les métaux désirés sont déposés par vaporisation par faisceau électronique ou bien par pulvérisation cathodique à haute fréquence.

3. Procédé selon les revendications 1 et 2, caractérisé en ce que la surface des substrats semi-conducteurs en silicium est nettoyée, en vue d'une préparation, avec une solution de gravure.

4. Procédé selon les revendications 1 à 3, caractérisé en ce que les substrats semi-conducteurs en silicium sont chauffés, avant le dépôt du métal, lentement jusqu'à la température désirée pour le substrat.

5. Procédé selon la revendication 4, caractérisé en ce que les substrats semi-conducteurs en silicium sont chauffés à une température comprise entre 330 et 550°C.

6. Procédé selon les revendications 1 et 2, caractérisé en ce que les métaux désirés sont déposés sous un vide poussé et sous une pression rentrant dans la plage comprise entre $1{,}33 \times 10^{-6}$ et $1{,}33 \times 10^{-7}$ mbar.

7. Procédé selon la revendication 1, caractérisé en ce que, pendant le dépôt d'un métal sur les substrats semi-conducteurs en silicium fraîchement nettoyés, les substrats semi-conducteurs en silcium portant des circuits intégrés sont isolés de la source du métal désiré au moyen d'un diaphragme.

8. Procédé selon les revendications 1 et 7, caractérisé en ce que le métal désiré est déposé sur les substrats semiconducteurs en silicium fraîchement nettoyés pendant environ 30 secondes et ensuite sur les substrats semi-conducteurs en silicium comportant des circuits intégrés pendant le temps correspondant à l'épaisseur de couche désirée.

9. Procédé selon les revendications 1, 2 et 6, caractérisé en ce que les substrats semi-conducteurs sont frittés, après le dépôt de la première couche métallique, à une température de 550 à 600°C pendant 15 à 30 minutes.

10. Dispositif pour revêtir de métal sous un vide poussé des substrats semi-conducteurs, caractérisé par un support de substrats (3), disposé de façon tournante dans une chambre à vide (9) et comportant les zones (1) et (2), une source (5) du métal à déposer et un diaphragme (7) à l'aide duquel des substrats semi-conducteurs en silicium pourvus de circuits intégrés et se trouvant dans la zone (2) peuvent être protégés de la source (5).

11. Dispositif selon la revendication 10, caractérisé en ce que des éléments chauffants (8) avec réflecteurs (4) sont placés au-dessus du support de substrats (3).

12. Dispositif selon la revendication 10, caractérisé en ce qu'un diaphragme (6) est disposé de façon tournante pour le réglage d'un point de départ défini lors de la vaporisation par l'intermédiaire de la source (5).

## Claims

1. Method of making ohmic and/or Schottky barrier contacts on a semiconductor substrate consisting of N-conductive silicon, by depositing on parts of the cleaned substrate with a first metal selected from the group consisting of platinum, palladium, nickel, rhodium, zirconium, hafnium, and by subsequent sintering, and by depositing on the thus formed metal silicide or another exposed part of the semiconductor substrate a second metal selected from the group consisting of aluminum, tantalum, titanium, tungesten, or titanium-tungsten, characterized in that for removing traces of oxygen in the vacuum chamber the desired metal is deposited on freshly cleaned silicon semiconductor substrates, at a low pressure and low temperature, and immediately afterwards in the same chamber onto silicon contact windows of semiconductor substrates with integrated circuits.

2. Method as claimed in claim 1, characterized in that the desired metals are deposited by means of electron beam evaporation, or by means of high frequency cathode sputtering.

3. Method as claimed in claims 1 and 2, characterized in that the surface of the silicon semiconductor substrates is pre-cleaned with an etching solution.

4. Method as claimed in any one of claims 1 to 3, characterized in that prior to the metal deposition, the silicon semiconductor substrates are slowly heated to the desired substrate temperature.

5. Method as claimed in claim 4, characterized in that the silicon semiconductor substrates are heated to a temperature in the range of 330 to 550°C.

6. Method as claimed in any one of claims 1 and 2, characterized in that the desired metals are deposited in a high vacuum at a pressure in the range of $1.33 \times 10^{-6}$ to $1.33 \times 10^{-7}$ mbar.

7. Method as claimed in claim 1, characterized in that during the metal deposition onto the freshly cleaned silicon semiconductor substrates the silicon semiconductor substrates with integrated circuits are masked out from the source of the desired metal by means of a shutter.

8. Method as claimed in any one of claims 1 and 7, characterized in that the desired metal is deposited onto the freshly cleaned silicon semiconductor substrates for approximately 30 seconds, and then onto the silicon semiconductor substrates with integrated circuits for the period corresponding to the respective layer thickness.

9. Method as claimed in any one of claims 1, 2 and 6, characterized in that following the deposition of the first metal layer, the semiconductor substrates are sintered for 15 to 30 minutes at a temperature from 550 to 600°C.

10. Device for depositing metal onto semiconductor substrates in a high vacuum, characterized by a substrate holder (3) rotatably arranged in a vacuum chamber (9), with the sectors (1) and (2), a source (5) of the metal to be deposited, and a shutter (7) with which silicon semiconductor substrates with integrated circuits in sector (2) can be masked out from the source (5).

11. Device as claimed in claim 10, characterized in that above the substrate holder (3) heating elements (18) with reflectors (4) are arranged.

12. Device as claimed in claim 10, characterized in that for setting a defined starting point a shutter (6) is rotatably arranged over the source (5) for evaporation.

11
15
12
15
8
13
15
14
15
15
10
9
3
1
N-
P+
N-
N+
P+
N+
P-
4
5
2
6
7

FIG. 1A

11
15'
12
15'
8
13
14
15'
10
9
3
1
N-
P+
N-
N+
P+
N+
P-
4
5
2
6
7

FIG. 1B

11
15'
12
15'
8
13
14
15'
10
9
3
1
N-
P+
N-
N+
P+
N+
P
4
5
2
6
7

FIG. 1C

26
24
22
20
10
9
3
1
N-
N+
P+
P+
P-
N-
N+
4
5
2
8
6
7
FIG. 1 D

11'
12'
32
28
13'
14'
15'
15'
30
15'
32
30
28
24
22
20
10
9
3
1
N-
N+
P+
P+
P-
N-
N+
4
5
2
8
6
7
FIG. 1 E

32
28
15'
34
15'
35
30
36
15'
37
32
30
28
10
9
3
1
N-
N+
P+
P+
P-
N-
N+
4
5
2
8
6
7
FIG. 1 F

FIG. 2
8
8
4
1
3
2
7
9
6
5
PUMPE